# EUROPÄISCHE PATENTSCHRIFT

(11) **EP 1 127 377 B1**
(45) Veröffentlichungstag und Bekanntmachung des Hinweises auf die Patenterteilung: **20.04.2005**
(21) Anmeldenummer: 99967992.1
(22) Anmeldetag: 30.12.1999
(51) Int. Cl.: H01L 27/02

(54) **ESD-SCHUTZTRANSISTOR**
ESD PROTECTIVE TRANSISTOR
TRANSISTOR DE SECURITE A DISSIPATION ELECTROSTATIQUE

(30) Priorität: 15.01.1999 DE 19901480; 21.10.1999 DE 19950811
(43) Veröffentlichungstag der Anmeldung: 29.08.2001
(73) Patentinhaber: Fraunhofer-Gesellschaft zur Förderung der angewandten Forschung e.V., 80686 München (DE); ROBERT BOSCH GmbH, 70469 Stuttgart (DE)
(72) Erfinder: WOLF, Heinrich, D-85716 Unterschleissheim (DE); WILKENING, Wolfgang, D-72793 Pfullingen (DE); METTLER, Stephan, D-72766 Reutlingen (DE)
(74) Vertreter: Schoppe, Fritz, Dipl.-Ing.
(86) Internationale Anmeldenummer: PCT/EP1999/010481
(87) Internationale Veröffentlichungsnummer: WO 2000/042658

(56) Entgegenhaltungen:
- EP-A- 0 092 671
- EP-A- 0 480 582
- EP-A- 0 822 596
- WO-A-94/03928
- US-A- 5 268 588
- US-A- 5 528 064
- US-A- 5 789 785
- CHEN J Z ET AL: "DESIGN AND LAYOUT OF A HIGH ESD PERFORMANCE NPN STRUCTURE FOR SUBMICRON BICMOS/BIPOLAR CIRCUITS" 1996 IEEE INTERNATIONAL RELIABILITY PHYSICS PROCEEDINGS,US,NEW YORK, IEEE, Bd. SYMP. 34, 1996, Seiten 227-232, XP000626581 ISBN: 0-7803-2754-3
- CORSI M ET AL: "ESD protection of BiCMOS integrated circuits which need to operate in the harsh environments of automotive or industrial" ELECTRICAL OVERSTRESS/ELECTROSTATIC DISCHARGE SYMPOSIUM PROCEEDINGS 1993, ELECTRICAL OVERSTRESS/ELECTROSTATIC DISCHARGE SYMPOSIUM PROCEEDINGS, LAKE BUENA VISTA, FL, USA, 28-30 SEPT. 1993, Seiten 209-213, XP002135564 1993, Rome, NY, USA, EOS/ESD Assoc, USA
- SCHROM G ET AL: "OVERVOLTAGE PROTECTION WITH A CMOS-COMPATIBLE BJT" PROCEEDINGS OF THE EUROPEAN SOLID STATE DEVICE RESEARCH CONFERENCE. (ESSDERC),FR,GIF-SUR-YVETTE, EDITIONS FRONTIERS, Bd. CONF. 23, 1993, Seiten 899-902, XP000473676

## Beschreibung

Die vorliegende Erfindung bezieht sich auf einen ESD-Schutztransistor und insbesondere auf einen ESD-Schutztransistor zum Schutz von integrierten Schaltungen (ICs) gegen elektrostatische Entladungen (ESD).

Bei Mischprozessen stehen Schutzelemente mit verschiedenen, durch technologische Parameter gegebenen, Durchbruchspannungen zur Verfügung, die für die entsprechenden Versorgungsspannungen ausgelegt sind. Derartige Versorgungsspannungen können beispielsweise bei 6V, 12V oder 20V liegen. Ist für eine Anwendung eine höhere Versorgungsspannung erforderlich, können diese Elemente nicht mehr verwendet werden.

Bei derartigen Anwendungen ist es beispielsweise möglich, MOS-Transistoren einzusetzen, deren Drain-Elektrode und Gate-Elektrode mittels Zenerdioden aktiv geklammert sind. Derartige bekannte ESD-Schutzvorrichtungen weisen jedoch einen sehr großen Flächenbedarf auf und sind daher kostenintensiv.

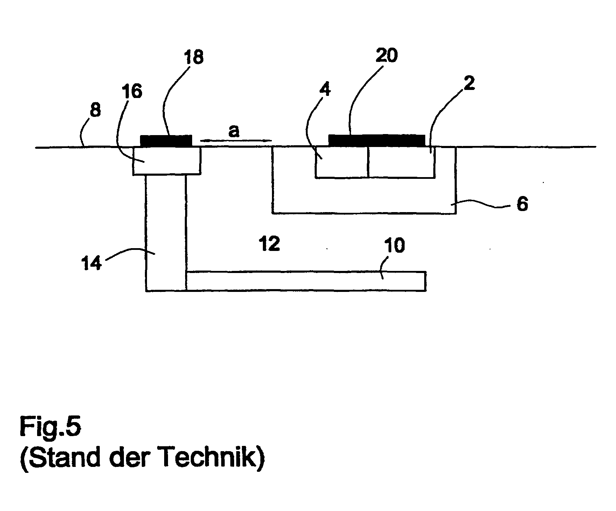

Eine weitere bekannte ESD-Schutzvorrichtung ist beispielsweise in der DE 19746410 A1 beschrieben, die die Verwendung eines vertikalen bipolaren Transistors lehrt, dessen Durchbruchspannung durch eine geeignete Layout-Maßnahme an die geforderte Versorgungsspannung angepaßt werden kann. Ein solcher vertikaler Transistor ist in Fig. 5 gezeigt, bei dem ein stark dotiertes p⁺-Basisgebiet 2 und ein stark dotiertes n⁺-Emittergebiet 4 in einer schwach dotierten p-Wanne 6, die in einem Halbleitersubstrat 8 gebildet ist, angeordnet sind. Ferner ist eine vergrabene, stark dotierte n⁺-Kollektorschicht 10 vorgesehen, die durch ein schwach dotiertes n-Gebiet 12 von der p-Wanne 6 getrennt ist. Die vergrabene n⁺-Kollektorschicht 10 ist über eine vertikale n⁺-Diffusion 14 mit einem stark dotierten n⁺-Bereich 16 in der Oberfläche des Substrats 8 verbunden. Der stark dotierte n⁺-Bereich 16 ist mit einer Kollektorelektrode 18 versehen, während der Basisbereich 2 und der Emitterbereich 4 über eine Basis-Emitter-Elektrode 20 kurzgeschlossen sind. Gemäß der DE 19746410 A1 ist der Abstand a zwischen dem stark dotierten n⁺-Bereich 16 und der schwach dotierten p-Wanne derart eingestellt, daß eine Lawinendurchbruchspannung zwischen diesen Bereichen durch den lateralen Abstand a und nicht durch den prozeßbedingten vertikalen Abstand zwischen vergrabener Schicht 10 und p-Wanne 6 festgelegt ist. Dabei sind der Basisbereich 2 und der Emitterbereich 4 kurzgeschlossen, so daß nach Einsetzen des kollektorseitigen Lawinendurchbruchs die p-Wanne 6 aufgeladen wird, so daß der vertikale Transistor zünden kann. Somit wird ein sehr niederohmiges Verhalten erreicht.

Der Nachteil der in Fig. 5 gezeigten Struktur ist die feste Haltespannung, die durch die nicht-veränderbare Basisweite und Basisdotierung des vertikalen Transistors definiert ist. Dies ist bei dem in Fig. 5 dargestellten Element dadurch bedingt, daß der Basisbereich 2 und der Emitterbereich 4 kurzgeschlossen sind, so daß nach dem Durchbruch der kollektorseitigen Raumladungszone der Transistoreffekt einsetzt und das Element auf seine spezifische Haltespannung, die durch die Basisweite gegeben ist, zurückspringt.

Um ein permanentes Einschalten des Schutztransistors während des regulären Betriebs sicher auszuschließen, ist jedoch eine Haltespannung erforderlich, die über der Versorgungsspannung der integrierten Schaltung liegt.

Aus der US-5,268,588 ist eine Halbleiterstruktur zum Schutz vor elektrostatischen Entladungen bekannt, die zwei Bipolartransistoren und einen Feldeffekttransistor aufweist. Der Emitter des ersten Bipolartransistors ist mit den Kollektoren des ersten und des zweiten Bipolartransistors verbunden, während der Emitter des zweiten Bipolartransistors mit einem Referenzspannungspotential verbunden ist.

Die EP 0 822 596 A offenbart eine Halbleiterschaltung mit ESD-Schutz, wobei eine ESD-Schutzschaltung durch eine npnp-Halbleiterstruktur, gebildet ist, die einen npn-Transistor und einen damit verschalteten pnp-Transistor darstellt, wobei der Emitter des npn-Transistors mit einem ersten Potential verbunden ist und der Emitter des pnp-Transistor mit einem Substratpotential verbunden ist.

Die WO 94/03928 A befaßt sich mit einer Halbleiter-Hochspannungsschutzschaltung, die eine Mehrzahl von Bipolartransistoren aufweist, deren Emitter jeweils mit externen Anschlüssen verbunden sind.

Chen J.Z. u.a. beschreiben in "Design and Layout of a High ESD Performance NPN Structure for Submicron BICMOS/Bipolar Circuits", 1996 IEEE International Reliability Physics Proceedings, US, New York, Bd. SYMP. 34, 1996, Seiten 227 - 232, Schaltungen zum Schutz vor elektrostatischen Entladungen, bei denen der Emitter eines Schutztransistors mit Masse verbunden ist.

Aus Corsi M. u.a., "ESD Protection of BiCMOS Integrated Circuits which Need to Operate in the Harsh Environments of Automotive or Industrial", Electrical Overstress/Electrostatic Discharge Symposium Proceedings, Lake Buena vista, FL, USA, 28.-30. Sept. 1993, Seiten 209 - 213 sind ebenfalls ESD-Schutzstrukturen bekannt, bei denen ein oder mehrere Bipolartransistoren zwischen eine Anschlußfläche und Masse geschaltet sind.

Die Aufgabe der vorliegenden Erfindung besteht darin, einen ESD-Schutztransistor zu schaffen, der einen flächensparenden ESD-Schutz für integrierte Schaltungen mit hohen Betriebsspannungen liefert.

Diese Aufgabe wird durch einen ESD-Schutztransistor gemäß Anspruch 1 gelöst.

Die vorliegende Erfindung schafft einen ESD-Schutztransistor mit einem in einer schwach dotierten p-Wanne angeordneten stark dotierten p-Basisbereich, der mit einem ersten Anschluß versehen ist. In der schwach dotierten p-Wanne ist ferner ein stark dotierter n-Emitterbereich vorgesehen. Ein stark dotierter n-Kollektorbereich ist durch einen schwach dotierten n-Bereich von der schwach dotierten p-Wanne getrennt und ist mit einem zweiten Anschluß versehen. Bei dem erfindungsgemäßen ESD-Schutztransistor ist der stark dotierte n-Emitterbereich nicht über eine gemeinsame Elektrode mit dem stark dotierten Basisbereich kurzgeschlossen und ist ferner floatend ausgeführt.

Alternativ können die Dotierungsarten der jeweiligen Bereiche vertauscht sein.

Die vorliegende Erfindung basiert auf der Erkenntnis, daß ein ESD-Schutztransistor mit einer erhöhten Haltespannung geschaffen werden kann, wenn der Emitterbereich des ESD-Schutztransistors nicht mit einem äußeren Anschluß versehen wird. Die Erfinder haben erkannt, daß bei dem in Fig. 5 gezeigten bekannten ESD-Schutzelement nach dem Einsetzen des kollektorseitigen Lawinendurchbruchs die pn-Basis-EmitterDiode durch den sich über die p-Wanne ergebenden Spannungsabfall in Flußrichtung gepolt wird, da der Basisbereich und der Emitterbereich über eine gemeinsame Elektrode kurzgeschlossen sind. Somit springt nach dem Einsetzen des kollektorseitigen Lawinendurchbruchs das Element auf seine spezifische Haltespannung zurück, die durch das Verhältnis zwischen der Stromverstärkung des kollektorseitigen Lawinendurchbruchs (Lawinenmultiplikation) und der Stromverstärkung aufgrund des Transistoreffekts definiert ist. Diese Haltespannung kann jedoch unterhalb der Betriebsspannung der zu schützenden integrierten Schaltung liegen, so daß ein Einschalten des Schutztransistors während des regulären Betriebs nicht sicher ausgeschlossen werden kann.

Erfindungsgemäß sind der hoch dotierte Basisbereich und der hoch dotierte Emitterbereich des ESD-Schutztransistors nunmehr nicht mehr über eine gemeinsame Elektrode kurzgeschlossen. Dadurch kommt es nach Einsetzen des kollektorseitigen Lawinendurchbruchs nicht mehr zu einer reinen Flußpolung des Basis-Emitter-Übergangs, wie es bei dem Element, das in Fig. 5 gezeigt ist, der Fall ist, sondern Teile des Basis-Emitter-Übergangs werden aufgrund des Potentials zwischen geerdetem Basisbereich und nicht-angeschlossenem Emitterbereich in Sperrichtung betrieben, so daß es erst beim Durchbruch der Basis-Emitter-Diode zum Einsetzen des Transistoreffekts kommt. Durch diesen Transistoreffekt springt das erfindungsgemäße ESD-Schutzelement auf eine Haltespannung zurück, die um den Betrag der Basis/Emitter-Durchbruchspannung höher ist als bei einem ESD-Schutztransistor, bei dem Basis und Emitter durch eine gemeinsame Elektrode kurzgeschlossen sind.

Bei bevorzugten Ausführungsbeispielen des erfindungsgemäßen ESD-Schutztransistors sind der Basisbereich und der Emitterbereich beabstandet voneinander in der Basiswanne angeordnet, so daß durch die Beabstandung derselben die Durchbruchspannung der Basis-Emitter-Diode einstellbar ist. Ferner kann bei bevorzugten Ausführungsbeispielen des erfindungsgemäßen ESD-Schutztransistors die Durchbruchspannung des kollektorseitigen Lawinendurchbruchs durch Einstellen des lateralen Abstands zwischen stark dotiertem Kollektorbereich und schwach dotierter Basiswanne eingestellt werden.

Die vorliegende Erfindung schafft somit einen ESD-Schutztransistor mit einer gegenüber bekannten ESD-Schutztransistoren erhöhten Haltespannung, wobei diese Haltespannung bei bevorzugten Ausführungsbeispielen der vorliegenden Erfindung im Layout durch den Abstand zwischen Basisbereich und Emitterbereich in der Basiswanne auf Spannungen oberhalb einer geforderten Versorgungsspannung einstellbar ist. Somit ist die erfindungsgemäße Struktur als ESD-Schutz für höhere Spannungen geeignet, ohne daß sie während des regulären Betriebs des integrierten Schaltkreises einschalten kann. Dadurch wird die Störanfälligkeit bei Schwankungen in der Spannungsversorgung wesentlich reduziert. Der verringerte Flächenbedarf gegenüber bisherigen Lösungsansätzen trägt darüber hinaus zu einer erheblichen Kostenreduktion bei.

Weiterbildungen der vorliegenden Erfindung sind in den abhängigen Ansprüchen dargelegt.

Bevorzugte Ausführungsbeispiele der vorliegenden Erfindung werden nachfolgend bezugnehmend auf die beiliegenden Zeichnungen näher erläutert. Es zeigen:
- Fig. 1: eine schematische Querschnittdarstellung eines ersten Ausführungsbeispiels eines erfindungsgemäßen ESD-Schutztransistors;
- Fig. 2: eine schematische Querschnittansicht eines zweiten Ausführungsbeispiels eines erfindungsgemäßen ESD-Schutztransistors;
- Fig. 3: eine schematische Draufsicht zur Veranschaulichung eines weiteren Ausführungsbeispiels eines erfindungsgemäßen ESD-Schutztransistors;
- Fig. 4: eine schematische Draufsicht zur veranschaulichung noch eines weiteren Ausführungsbeispiels eines erfindungsgemäßen ESD-Schutztransistors; und
- Fig. 5: eine schematische Querschnittansicht eines bekannten ESD-Schutztransistors.

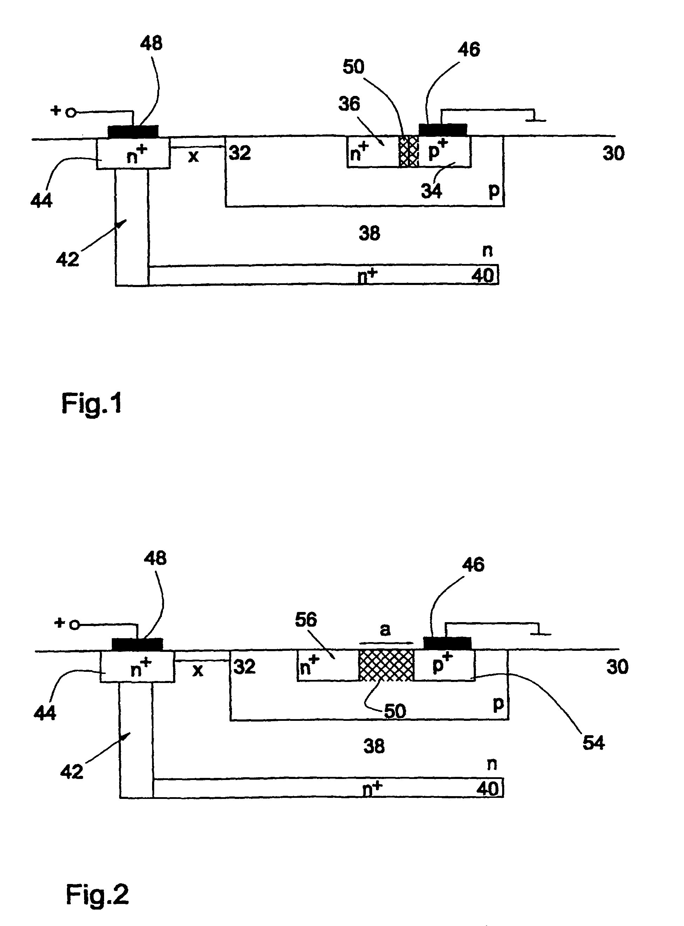

Fig. 1 zeigt die Struktur eines ersten Ausführungsbeispiels eines ESD-Schutztransistors nach der vorliegenden Erfindung. Zunächst sei angemerkt, daß im folgenden Ausführungsbeispiele der vorliegenden Erfindung bezugnehmend auf bestimmte Dotierungsarten beschrieben werden. Es ist für Fachleute jedoch klar, daß die Dotierungstypen jeweils vertauscht sein können.

Wie in Fig. 1 gezeigt ist, ist in einer Oberfläche eines Halbleitersubstrats 30 eine vertikale Transistorstruktur gebildet. In einer schwach dotierten p-Wanne 32 sind dabei ein stark dotierter p⁺-Basisbereich und ein stark dotierter n⁺-Emitterbereich 36 angeordnet. Durch einen schwach dotierten n-Bereich 38 von der p-Wanne 32 getrennt, ist eine vergrabene stark dotierte n⁺-Kollektorschicht 40, die über einen stark dotierten n⁺-Sinker 42 mit einem durch eine laterale Diffusion erzeugten stark dotierten n⁺-Kollektorbereich 44 verbunden ist. Bei bevorzugten Ausführungsbeispielen des erfindungsgemäßen ESD-Schutztransistors ist die kollektorseitige Lawinendurchbruchspannung über das schwach dotierte n-Gebiet 38 einstellbar, indem der laterale Abstand x zwischen dem hoch dotierten n⁺-Bereich 44 und der schwach dotierten p-Wanne 32 eingestellt wird. Diesbezüglich ist anzumerken, daß es für eine gute Einstellbarkeit bevorzugt ist, den n⁺-Bereich 44 mittels einer lateralen Diffusion zu erzeugen. Ferner kann den n⁺-Bereich umgebend ein n-Gebiet (nicht gezeigt) einer starken Dotierungsdichte im Bereich von 10¹⁹/cm³ angeordnet sein, das durch eine laterale Diffusion mit exakten Abmessungen erzeugt werden kann, so daß der Abstand x und damit die Lawinendurchbruchspannung ebenfalls sehr exakt eingestellt werden können.

Wie ferner in Fig. 1 zu sehen ist, ist der Basisbereich 34 mit einer ersten Anschlußelektrode 46 versehen, während der Kollektorbereich 44 mit einer zweiten Anschlußelektrode 48 versehen ist. Im Gegensatz dazu besitzt der Emitterbereich 36 keinen äußeren Anschluß. Das erfindungsgemäße ESD-Schutzelement wird mit den Anschlüssen 46 und 48 zwischen den Eingang einer zu schützenden integrierten Schaltung und Masse geschaltet, um eine elektrostatische Entladung, die eine vorbestimmte Spannung übersteigt und andernfalls am Eingang der integrierten Schaltung anliegen würde, auf Masse abzuleiten. Dabei kann der ESD-Schutztransistor vorzugsweise auf dem gleichen Substrat wie die integrierte Schaltung gebildet sein.

Bei dem in Fig. 1 gezeigten vertikalen Transistor bilden das schwach dotierte n-Gebiet 38 und die schwach dotierte p-Wanne 32 den kollektorseitigen pn-Übergang. Wie oben erwähnt wurde, ist die Durchbruchspannung dieses Übergangs durch Layoutmaßnahmen, nämlich die Einstellung des Abstands x, einstellbar. Im folgenden wird nun kurz die Funktionsweise des in Fig. 1 dargestellten ESD-Schutztransistors erläutert. Wie oben erläutert wurde, ist der Emitter des erfindungsgemäßen ESD-Schutztransistors nicht angeschlossen, d.h. derselbe "floatet". Dadurch wirkt die Struktur zunächst als Diode. Liegt nun eine ausreichende Sperrspannung zwischen den Anschlüssen 46 und 48 vor, steigt mit zunehmendem Lawinenstrom über den kollektorseitigen pn-Übergang das Potential zwischen dem über den Anschluß 46 geerdeten Basisbereich 34 und dem nicht-angeschlossenen Emitterbereich 36. Da der Emitterbereich 36 keinen äußeren Anschluß aufweist, können die Ladungsträger in demselben nicht abfließen, was zu einem zunehmenden Sperrpotential zwischen Emitter 36 und Basis 34 führt, was schließlich einen Durchbruch der Emitter-Basis-Diode zur Folge hat, wobei die Durchbruchzone in Fig. 1 durch das Bezugszeichen 50 angezeigt ist. Mit diesem Durchbruch der Emitter-Basis-Diode setzt ein bipolarer Transistoreffekt ein, durch den das ESD-Schutzelement auf eine Haltespannung zurückspringt, die um den Betrag der Basis-Emitter-Durchbruchspannung höher ist als bei einem ESD-Schutztransistor, bei dem Emitter und Basis kurzgeschlossen sind.

In Fig. 2 ist ein Ausführungsbeispiel der erfindungsgemäßen ESD-Schutzvorrichtung gezeigt, bei dem die Haltespannung weiter erhöht ist, indem zwischen dem stark dotierten p⁺-Basisbereich 54 und dem stark dotierten n⁺-Emitterbereich 56, die in der schwach dotierten p-Wanne 32 angeordnet sind, ein Abstand a vorgesehen ist. Im übrigen entsprechen die Elemente des in Fig. 2 dargestellten Ausführungsbeispiels denen, die bezüglich Fig. 1 beschrieben wurden, und sind mit gleichen Bezugszeichen bezeichnet. Durch das Vorsehen eines Abstands a zwischen dem hoch dotierten Basisbereich 54 und dem hoch dotierten Emitterbereich 56 kann die Durchbruchspannung der Basis-Emitter-Diode erhöht werden. Da, wie oben erläutert, die Haltespannung des ESD-Schutztransistors von der Durchbruchspannung der Basis-Emitter-Diode abhängt, kann somit durch eine Einstellung des Abstands a zwischen dem hoch dotierten Basisbereich 54 und dem hoch dotierten Emitterbereich 56 die Haltespannung des ESD-Schutztransistors beeinflußt werden. Die Untergrenze der Durchbruchspannung ist dabei durch den p⁺/n⁺-Übergang für a = 0 µm gegeben, was der in Fig. 1 gezeigten Struktur entspricht. Die Obergrenze ist für einen ausreichend großen Abstand a durch den Übergang zwischen stark dotiertem n⁺-Emitterbereich 56 und schwach dotierter p-Wanne 32 gegeben.

Da, wie oben erläutert, während einer ESD-Belastung neben der kollektorseitigen Raumladungszone auch Teile der Basis-Emitter-Diode in Sperrichtung betrieben werden, kann die zwischen Basis- und Emitter-Bereich zusätzlich umgesetzte Leistung zu einer niedrigen Ausfallschwelle führen. Deshalb ist es zweckmäßig, den Raum für den Basis-Emitter-Durchbruch möglichst groß zu wählen, um so die auftretende Leistungsdichte in dieser Raumladungszone zwischen Basis- und Emitter-Bereich zu verringern.

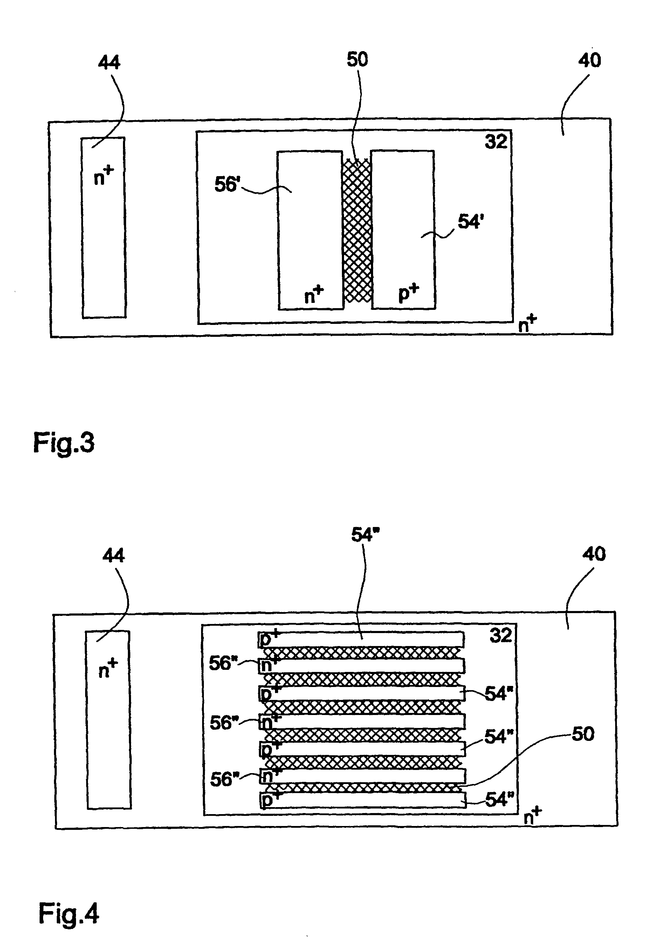

Fig. 3 zeigt ein einfaches erstes Ausführungsbeispiel, bei dem der Basisbereich 54' und der Emitterbereich 56' mit einer länglichen Form ausgebildet sind, so daß dieselben vergrößerte gegenüberliegende benachbarte Randbereiche aufweisen, die einen Raum für einen Basis-Emitter-Durchbruch definieren. Die Durchbruchzone ist wiederum mit dem Bezugszeichen 50 bezeichnet.

In Fig. 4 ist ein weiteres Ausführungsbeispiel für das Layout des Basis-Emitter-Gebiets dargestellt, wobei hier der zwischen gegenüberliegenden benachbarten Randbereichen des Basisbereichs 54" und des Emitterbereichs 56" definierte Raum für einen Basis-Emitter-Durchbruch im wesentlichen maximiert ist. Zu diesem Zweck sind bei dem in Fig. 4 dargestellten Ausführungsbeispiel eine Mehrzahl von länglichen Emitterbereichen 56" und länglichen Basisbereichen 54" derart bezüglich zueinander angeordnet, daß jeweils zwischen den Längsseiten derselben Zwischenräume, die einen Raum für einen Emitter-Basis-Durchbruch definieren, angeordnet sind. Dadurch kann die Leistungsdichte über die in Sperr-Richtung betriebene Basis-Emitter-Diode stark reduziert sein. In Fig. 4 ist lediglich eine zwischen jeweiligem Emitterbereich und Basisbereich angeordnete Durchbruchzone mit dem Bezugszeichen 50 bezeichnet.

Die unterschiedlich dotierten Halbleiterbereiche des ESD-Schutztransistors gemäß der vorliegenden Erfindung können mit üblichen Dotierungspegeln dotiert sein. Beispielsweise kann die schwach dotierte p-Wanne 32 eine Dotierungsdichte von 10¹⁷/cm³ aufweisen, während die Dotierungdichte des schwach dotierten n-Bereichs 38 10¹⁵/cm³ betragen kann. Die stark dotierten Bereiche 34, 36 und besitzen vorzugsweise eine Dotierungsdichte über 10¹⁹ cm³.

Die vorliegende Erfindung schafft somit ESD-Schutztransistoren mit einer erhöhten Haltespannung, wobei bei bevorzugten Ausführungsbeispielen die Haltespannung durch das Einstellen des Abstands zwischen Basisbereich und Emitterbereich einstellbar ist, um oberhalb einer geforderten Versorgungsspannung zu liegen. Somit ist das erfindungsgemäße ESD-Schutzelement für höhere Spannungen geeignet, wobei gewährleistet ist, daß dasselbe während des regulären Betriebs des integrierten Schaltkreises nicht einschaltet. Somit ist die Störanfälligkeit bei Schwankungen der Versorgungsspannung wesentlich reduziert. Darüber hinaus trägt ein verringerter Flächenbedarf gegenüber bisherigen Konzepten zu einer erheblichen Kostenreduktion bei.

## Patentansprüche

1. ESD-Schutztransistor mit folgenden Merkmalen:
einem in einer schwach dotierten Wanne (32) eines ersten Dotierungstyps angeordneten stark dotierten Basisbereich (34; 54; 54'; 54") des ersten Dotierungstyps, der mit einem ersten Anschluß (46) versehen ist;
einem in der schwach dotierten Wanne (32) des ersten Dotierungstyps angeordneten stark dotierten Emitterbereich (36; 56; 56'; 56") eines zweiten Dotierungstyps; und
einem stark dotierten Kollektorbereich (40, 42, 44) des zweiten Dotierungstyps, der durch einen schwach dotierten Bereich (38) des zweiten Dotierungstyps von der schwach dotierten Wanne (32) des ersten Dotierungstyps getrennt ist und mit einem zweiten Anschluß (48) versehen ist,
wobei
der stark dotierte Emitterbereich (36; 56; 56'; 56") des zweiten Dotierungstyps nicht über eine gemeinsame Elektrode mit dem stark dotierten Basisbereich des ersten Dotierungstyps kurzgeschlossen ist und floatend ausgebildet ist.

2. ESD-Schutztransistor gemäß Anspruch 1, bei dem der stark dotierte Basisbereich (54; 54'; 54") des ersten Dotierungstyps und der stark dotierte Emitterbereich (56; 56'; 56") des zweiten Dotierungstyps beabstandet voneinander in der schwach dotierten Wanne (32) des ersten Dotierungstyps angeordnet sind.

3. ESD-Schutztransistor gemäß Anspruch 1 oder Anspruch 2, der ein vertikaler Transistor mit einem vergrabenen Kollektorbereich (40) ist.

4. ESD-Schutztransistor gemäß Anspruch 3, bei dem der vergrabene Kollektorbereich (40) bis zu einem in der Oberfläche des Substrats, in dem der ESD-Schutztransistor gebildet ist, gebildeten stark dotierten Oberflächenbereich (44) des zweiten Dotierungstyps, auf dem der zweite Anschluß (48) angeordnet ist, reicht, wobei die Lawinendurchbruchspannung zwischen der schwach dotierten Wanne (32) des ersten Dotierungstyps und dem stark dotierten Kollektorbereich (40, 42, 44) des zweiten Dotierungstyps über den schwach dotierten Bereich (38) des zweiten Dotierungstyps durch den lateralen Abstand (x) zwischen dem stark dotierten Oberflächenbereich (44) des zweiten Dotierungstyps und der schwach dotierten Wanne (32) des ersten Dotierungstyps definiert ist.

5. ESD-Schutztransistor gemäß einem der Ansprüche 1 bis 4, bei dem der Basisbereich (54'; 54") und der Emitterbereich (56'; 56") derart ausgebildet sind, daß der zwischen gegenüberliegenden benachbarten Randbereichen des Basisbereichs (54'; 54") und des Emitterbereichs (56'; 56") definierte Raum für einen Basis-Emitter-Durchbruch maximiert ist.

6. ESD-Schutztransistor gemäß einem der Ansprüche 1 bis 5, bei dem der erste Dotierungstyp eine p-Dotierung und der zweite Dotierungstyp eine n-Dotierung ist.

## Claims

1. An ESD protective transistor, comprising:
a heavily doped base region (34; 54; 54'; 54") of a first doping type arranged in a lightly doped well (32) of the first doping type and provided with a first terminal (46);
a heavily doped emitter region (36; 56; 56'; 56") of a second doping type arranged in said lightly doped well (32) of the first doping type; and
a heavily doped collector region (40, 42, 44) of the second doping type separated from said lightly doped well (32) of the first doping type by a lightly doped region (38) of the second doping type and provided with a second terminal (48),
wherein
the heavily doped emitter region (36; 56; 56'; 56") of the second doping type is not shorted together with the heavily doped base region of the first doping type via a common electrode and is configured to be floating.

2. The ESD protective transistor according to claim 1, wherein the heavily doped base region (54; 54', 54") of the first doping type and the heavily doped emitter region (56; 56'; 56") of the second doping type are arranged in the lightly doped well (32) of the first doping type in spaced apart manner.

3. The ESD protective transistor according to claim 1 or claim 2, which is a vertical transistor having a buried collector region (40).

4. The ESD protective transistor according to claim 3, wherein the buried collector region (40) extends as far as a heavily doped surface region (44) of the second doping type which is formed in the surface of the substrate having the ESD protective transistor formed therein and on which said second terminal (48) is arranged, the avalanche breakdown voltage between the lightly doped well (32) of the first doping type and the heavily doped collector region (40, 42, 44) of the second doping type across the lightly doped region (38) of the second doping type being defined by the lateral distance (x) between the heavily doped surface region (44) of the second doping type and the lightly doped well (32) of the first doping type.

5. The ESD protective transistor according to any of claims 1 to 4, wherein the base region (54'; 54") and the emitter region (56'; 56") are formed such that the space defined between opposing adjacent edge portions of the base region (54'; 54") and the emitter region (56'; 56") is maximized for a base-emitter breakdown.

6. The ESD protective transistor according to any of claims 1 to 5, wherein the first doping type is a p-type doping, and the second doping type is an n-type doping.

## Revendications

1. Transistor de sécurité à dissipation électrostatique avec :
une zone de base hautement dopée (34 ; 54 ; 54' ; 54") du premier type de dopage, disposée dans une cuvette faiblement dopée (32) d'un premier type de dopage, qui est pourvue d'une première connexion (46) ;
une zone d'émetteur hautement dopée (36 ; 56 ; 56' ; 56") d'un deuxième type de dopage disposée dans la cuvette faiblement dopée (32) du premier type de dopage ; et
une zone de collecteur hautement dopée (40, 42, 44) du deuxième type de dopage qui est séparée, par une zone faiblement dopée (38) du deuxième type de dopage, de la cuvette faiblement dopée (32) du premier type de dopage et qui est pourvue d'une deuxième connexion (48),
la zone d'émetteur hautement dopée (36 ; 56 ; 56' ; 56") du deuxième type de dopage n'étant pas court-circuitée par l'intermédiaire d'une électrode commune avec la zone de base hautement dopée du premier type de dopage et étant réalisée flottante.

2. Transistor de sécurité à dissipation électrostatique selon la revendication 1, dans lequel la zone de base hautement dopée (54 ; 54' ; 54") du premier type de dopage et la zone d'émetteur hautement dopée (56 ; 56' ; 56") du deuxième type de dopage sont disposées distantes l'une de l'autre dans la cuvette faiblement dopée (32) du premier type de dopage.

3. Transistor de sécurité à dissipation électrostatique selon la revendication 1 ou la revendication 2, qui est un transistor vertical avec une zone de collecteur enterrée (40).

4. Transistor de sécurité à dissipation électrostatique selon la revendication 3, dans lequel la zone de collecteur enterrée (40) s'étend jusqu'à une zone de surface hautement dopée (44) du deuxième type de dopage formée dans la surface du substrat dans laquelle est formé le transistor de sécurité à dissipation électrostatique et sur laquelle est formée la deuxième connexion (48), la tension de rupture par avalanche entre la cuvette faiblement dopée (32) du premier type de dopage et la zone de collecteur hautement dopée (40, 42, 44) du deuxième type de dopage étant définie par l'intermédiaire de la zone faiblement dopée (38) du deuxième type de dopage par la distance latérale (x) entre la zone de surface hautement dopée (44) du deuxième type de dopage et la cuvette faiblement dopée (32) du premier type de dopage.

5. Transistor de sécurité à dissipation électrostatique selon l'une des revendications 1 à 4, dans lequel la zone de base (54' ; 54") et la zone d'émetteur (56' ; 56") sont réalisées de sorte que l'espace défini entre des zones de bordure adjacentes opposées de la zone de base (54' ; 54") et de la zone d'émetteur (56' ; 56") soit maximisé pour une rupture entre base et émetteur.

6. Transistor de sécurité à dissipation électrostatique selon l'une des revendications 1 à 5, dans lequel le premier type de dopage est un dopage p et le deuxième type de dopage est un dopage n.
